# FASCICULE DE BREVET EUROPEEN

(11) **EP 4 472 372 B1**
(45) Date de publication et mention de la délivrance du brevet: **17.12.2025**
(21) Numéro de dépôt: 24178563.3
(22) Date de dépôt: 28.05.2024
(51) Int. Cl.: H05K 7/20, H01L 21/48, H01L 23/367, H01L 23/467

(54) **APPAREIL DE REGULATION THERMIQUE ET EQUIPEMENT ELECTRONIQUE ASSOCIE**
WÄRMEREGELUNGSVORRICHTUNG UND ELEKTRONISCHE VORRICHTUNG DAFÜR
THERMAL CONTROL APPARATUS AND ELECTRONIC EQUIPMENT THEREOF

(30) Priorité: 02.06.2023 FR 2305558
(43) Date de publication de la demande: 04.12.2024
(73) Titulaire: SAGEMCOM BROADBAND SAS, 92270 Bois-Colombes (FR)
(72) Inventeur: JEANROT, Nathan, 92270 Bois-Colombes (FR); MAURECH, Cécile, 92270 Bois-Colombes (FR)
(74) Mandataire: Cabinet Boettcher

(56) Documents cités:
- US-A- 5 653 285
- US-A1- 2007 215 336
- US-A1- 2019 335 614

## Description

L'invention concerne un appareil de régulation thermique.

L'invention concerne également un équipement électronique comprenant un tel appareil de régulation thermique.

### ARRIERE PLAN DE L'INVENTION

Dans le domaine de l'électronique, il est connu d'associer aux équipements électroniques des appareils de régulation thermique afin de faciliter l'évacuation de la chaleur dégagée par lesdites équipements électroniques pour éviter leur endommagement.

Usuellement un appareil de régulation thermique est formé d'une unique pièce présentant une semelle prolongée en partie supérieure d'ailettes. La semelle est par exemple destinée à être apposée sur une carte électronique telle qu'une carte à circuits imprimés de sorte que la semelle s'étende parallèlement à la carte. L'appareil de régulation thermique est usuellement en aluminium pour faciliter les échanges thermiques.

Les appareils de régulation thermique en aluminium sont généralement fabriqués soit par extrusion soit par injection afin que les ailettes soient venues de matière avec la semelle.

La fabrication par extrusion permet de réaliser des pièces présentant des épaisseurs plus fines ce qui réduit considérablement le volume et le poids desdites pièces. En outre, l'aluminium utilisé est plus performant thermiquement que celui utilisé pour la fabrication par injection. La fabrication par extrusion ne permet toutefois de réaliser que des pièces de formes simples. En cas de besoin d'une pièce particulière avec des formes techniques, il est alors nécessaire après l'extrusion de réaliser des reprises sur la pièce déjà réalisée ce qui augmente le coût de production de la pièce.

La fabrication par injection permet en revanche de fabriquer des pièces complexes.

Néanmoins les pièces produites ont alors une épaisseur conséquente et l'aluminium utilisé présente de moins bonnes performances thermiques qu'avec l'extrusion.

Les pièces réalisées sont ainsi lourdes et chères.

De plus, si l'on souhaite compenser le manque de performances thermiques desdites pièces, il faut alors en augmenter les dimensions ce qui les alourdit et augmente d'autant plus leurs coûts de fabrication.

Les documents US 5 653 285 et US 2019/335614 décrivent des appareils de régulation thermique de l'art antérieur.

### OBJET DE L'INVENTION

Un but de l'invention est de proposer une solution permettant d'obvier au moins en partie à au moins l'un des inconvénients précités.

### RESUME DE L'INVENTION

A cet effet, on prévoit, un appareil de régulation thermique comprenant au moins :
- Une platine,
   Au moins deux dissipateurs rapportés sur la platine, chaque dissipateur comprenant au moins une ouverture à travers laquelle un écoulement d'air est destiné à circuler, les deux dissipateurs étant rapportés sur la platine de sorte que leurs ouvertures soient décalées l'une par rapport à l'autre et/ou de sorte qu'au moins une paroi dessinant au moins une des ouvertures se trouve dans l'alignement de l'autre ouverture,
   dans lequel les dissipateurs sont rapportés sur la platine de sorte à s'étendre les uns à la suite des autres selon un axe,
   l'appareil comportant entre deux et six groupes de dissipateurs thermiques, les dissipateurs étant identiques au sein d'un même groupe mais différents entre deux groupes,
- les dissipateurs étant agencés de sorte à alterner sur au moins une zone de l'appareil successivement, selon l'axe (Y), un dissipateur de chacun des groupes.

De la sorte, la platine et les dissipateurs sont fabriqués de manière séparée puis assemblés dans un deuxième temps. Ceci offre une plus grande liberté de placement des dissipateurs sur la platine.

En particulier, il est ainsi possible de décaler les ouvertures des dissipateurs (décalage angulaire et/ou décalage transversal) et/ou d'avoir des ouvertures de formes différentes. De la sorte l'écoulement d'air (naturel ou forcé) qui circule dans l'invention rencontre des obstacles (les dissipateurs) qui perturbent l'écoulement d'air en le divisant et/ou en modifiant son orientation.

Ceci favorise les échanges thermiques entre les dissipateurs et l'écoulement d'air.

L'appareil de régulation thermique s'avère particulièrement efficace.

En outre, du fait que l'invention permet d'optimiser les échanges thermiques avec l'air environnant, l'appareil de régulation thermique peut être de dimensions relativement réduites.

Il s'avère de plus léger et relativement peu coûteux à produire.

En particulier, le fait de pouvoir produire de manière séparée platine et dissipateurs permet de pouvoir facilement produite en grandes séries.

Ceci permet de réduire les coûts de production.

L'invention concerne également un équipement électronique équipé d'un tel appareil de régulation thermique.

Optionnellement au moins l'un des dissipateurs présente un orifice et au moins une cloison traversant ledit orifice de sorte à le découper en deux ouvertures.

Optionnellement la paroi se trouvant dans l'alignement de l'autre ouverture est la cloison.

Optionnellement la cloison a une épaisseur comprise entre 1 et 3 millimètres.

Optionnellement la cloison s'étend de manière inclinée relativement à au moins une paroi supérieure, une paroi inférieure ou un flanc latéral du dissipateur associé.

Optionnellement chacun des dissipateurs comporte une cloison s'étendant de manière inclinée relativement à au moins une paroi supérieure, une paroi inférieure ou un flanc latéral du dissipateur associé.

Optionnellement les ouvertures sont décalées angulairement l'une par rapport à l'autre et/ou sont décalés transversalement l'une par rapport à l'autre.

Optionnellement les dissipateurs sont agencés de manière parallèle entre eux.

Optionnellement les dissipateurs sont décalés l'un de l'autre selon une direction longitudinale de la platine.

Optionnellement les au moins deux dissipateurs présentent une géométrie différente.

Optionnellement la platine et/ou au moins l'un des dissipateurs est en ou à base d'alliage d'aluminium.

Optionnellement la platine et/ou au moins l'un des dissipateurs est une pièce injectée ou extrudée.

Optionnellement la platine et au moins l'un des dissipateurs sont dans le même matériau.

Optionnellement au moins l'un des dissipateurs est muni d'au moins une patte par l'intermédiaire duquel il repose contre la platine.

L'invention concerne également un équipement électronique équipé d'un appareil de régulation thermique tel que précité.

Optionnellement, l'équipement électronique est une carte électronique.

D'autres caractéristiques et avantages de l'invention ressortiront à la lecture de la description qui suit de modes de réalisation particuliers et non limitatifs de l'invention.

### BREVE DESCRIPTION DES DESSINS

Il sera fait référence aux dessins annexés, parmi lesquels :
[Fig. 1] la figure 1 est une vue en perspective d'un appareil de dissipation thermique selon un premier mode de réalisation de l'invention associé à une carte à circuits imprimées ;
[Fig. 2] la figure 2 est une vue de dessus d'une platine de l'appareil illustré à la figure 1 ;
[Fig. 3] la figure 3 est une vue de côté d'un dissipateur de l'appareil illustré à la figure 1 ;
[Fig. 4] la figure 4 est une vue de dessus de l'appareil illustré à la figure 1 ;
[Fig. 5] la figure 5 est une vue similaire à celle de la figure 4, les flux d'air circulant à travers l'appareil étant symbolisés par des flèches ;
[Fig. 6] la figure 6 est une vue en perspective d'un appareil de dissipation thermique selon un deuxième mode de réalisation de l'invention associé à une carte à circuits imprimées ;
[Fig. 7] la figure 7 est une vue de dessus d'une platine de l'appareil illustré à la figure 6 ;
[Fig. 8] la figure 8 est une vue en perspective d'un dissipateur de l'appareil illustré à la figure 6 ;
[Fig. 9] la figure 9 est une vue de dessus de l'appareil illustré à la figure 6 ;
[Fig. 10] la figure 10 est une vue similaire à celle de la figure 9, les flux d'air circulant à travers l'appareil étant symbolisés par des flèches.

### DETAILLEE DE L'INVENTION

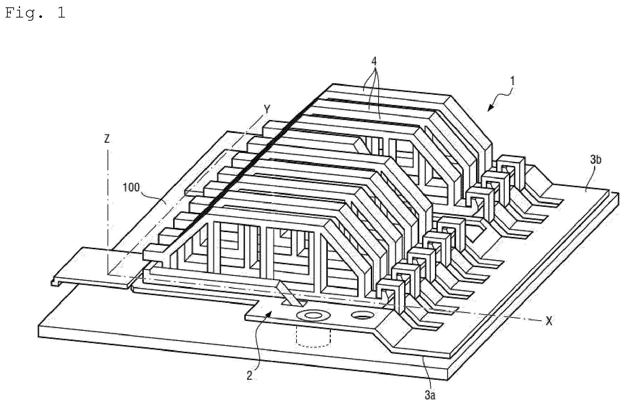

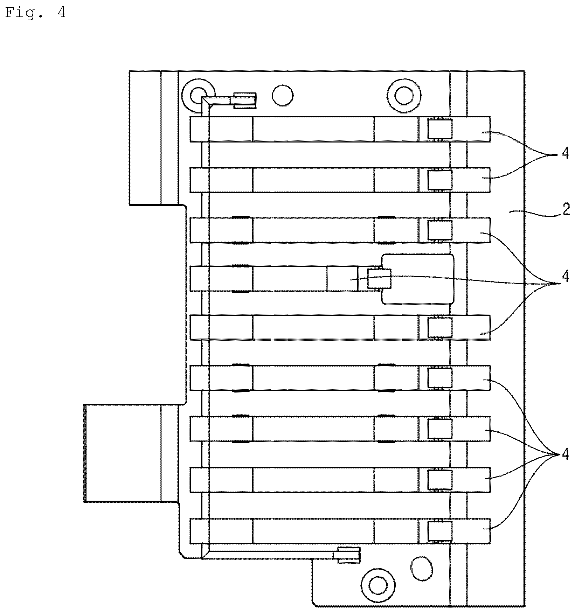

En référence aux figures 1 à 5, un premier mode de réalisation va être décrit.

L'appareil 1 de régulation thermique est associé à un équipement électronique 100 afin de réguler thermiquement ledit équipement électronique 100. L'équipement électronique 100 est par exemple une carte électronique telle qu'une carte à circuit imprimés.

L'appareil 1 comprend une platine 2 qui est conformée en une plaquette. La platine 2 présente ainsi une épaisseur bien moins importante que ses autres dimensions. La platine 2 présente ainsi deux faces principales : une première face principale 3a et une deuxième face principale 3b.

L'appareil 1 est agencé de sorte que la première face principale 3a s'étende en regard d'une des faces de l'équipement électronique 100. Dans le cas présent, la première face principale 3a s'étend en regard d'une des faces principales de l'équipement électronique 100. De préférence, l'appareil 1 est agencé de sorte que la première face principale 3a s'étende parallèlement à l'une des faces principales de l'équipement électronique 100.

La platine 2 est ici fixée à l'équipement électronique 100. La platine 2 est ainsi apposée sur l'équipement électronique 100 et se trouve en contact avec au moins une zone de l'équipement électronique 100.

La liaison entre la platine 2 et l'équipement électronique 100 est similaire à celle d'une semelle d'un appareil de régulation thermique de l'art antérieur et ne sera donc pas détaillée ici.

L'appareil 1 comporte par ailleurs une pluralité de dissipateurs 4 (dont une partie seulement est référencée à la figure 1) rapportés sur la deuxième face principale 3b de la platine 2. L'appareil 1 comprend par exemple entre 2 et 12 dissipateurs 4 et par exemple entre 2 et 9 dissipateurs 4.

Les différents dissipateurs 4 sont rapportés sur la platine 2 de sorte à s'étendre ici parallèlement les uns aux autres. Par exemple les dissipateurs 4 sont agencés de sorte à s'étendre parallèlement aux bords latéraux de la platine 2 qui s'étendent eux-mêmes parallèlement à un axe X. La deuxième face principale 3b est ainsi définie par un plan contenant l'axe X et un axe Y orthogonal à l'axe X.

Les dissipateurs 4 sont par ailleurs agencés sur la platine 2 de sorte que leur largeur s'étende parallèlement à l'axe Y et leur longueur s'étende parallèlement à l'axe X.

Les dissipateurs 4 sont par ailleurs rapportés sur la platine 2 de sorte à s'étendre les uns à la suite des autres selon l'axe Y. Par exemple la distance (selon l'axe Y) entre deux dissipateurs 4 successifs est supérieure à 4 millimètres et par exemple supérieure à 5 millimètres. Par exemple la distance (selon l'axe Y) entre deux dissipateurs 4 successifs est inférieure à 50 millimètres et par exemple inférieure à 40 millimètres. Optionnellement, l'intervalle entre deux dissipateurs 4 successifs est le même sur toute la longueur (selon l'axe Y) de la deuxième face principale 3b.

Chaque dissipateur 4 présente deux faces principales s'étendant parallèlement entre elles. Ici, chaque dissipateur est conformé de sorte que ses deux faces principales s'étendent parallèlement à un plan contenant l'axe X et un axe Z qui est orthogonal à l'axe X et à l'axe Y (l'épaisseur de la platine 2 étant définie le long de cet axe Z).

On va à présent décrire l'un des dissipateurs 4, la description qui suit s'appliquant également aux autres dissipateurs 4 dans le cas présent.

Le dissipateur 4 est formé de plusieurs parois, chaque paroi étant conformée en une plaquette. Le dissipateur 4 est de préférence d'une seule pièce. De préférence, les différentes parois formant le dissipateur 4 ont une épaisseur comprise entre 1 et 3 millimètres. Au moins deux parois d'un même dissipateur 4 peuvent optionnellement avoir la même épaisseur.

Le dissipateur 4 présente une paroi inférieure 5 montée en regard de la platine 2 et montée optionnellement parallèlement à la deuxième face principale 3b. La paroi inférieure 5 s'étend ainsi dans un plan parallèle aux axes X et Y. La paroi inférieure 5 est conformée en une plaque. La paroi inférieure 5 est optionnellement munie d'au moins une patte et par exemple d'au moins deux pattes 6 par l'intermédiaire desquelles le dissipateur 4 repose sur la platine 2.

Les contacts avec le dissipateur 4 et la platine 2 sont ainsi de faibles dimensions.

Les pattes 6 peuvent par ailleurs faciliter le positionnement du dissipateur 4 sur la platine 2.

Le dissipateur 4 comporte optionnellement au moins une paroi supérieure 7 agencée au-dessus de la paroi inférieure 5 et s'étendant optionnellement parallèlement à la paroi inférieure 5. La paroi supérieure 7 s'étend ainsi dans un plan parallèle aux axes X et Y. La paroi supérieure 7 est conformée en une plaque.

Le dissipateur 4 comporte par ailleurs des flancs latéraux 8 pour relier les parois inférieure 5 et supérieure 7 entre elles.

Par exemple le flanc latéral gauche 8 comporte une première paroi 9a et une deuxième paroi 9b, la première paroi 9a s'étendant depuis la paroi inférieure 5 jusqu'à la deuxième paroi 9b et la deuxième paroi 9b s'étendant depuis la première paroi 9a jusqu'à la paroi supérieure 7. De même le flanc latéral droit 8 comporte une première paroi 10a et une deuxième paroi 10b, la première paroi 10a s'étendant depuis la paroi inférieure 5 jusqu'à la deuxième paroi 10b et la deuxième paroi 10b s'étendant depuis la première paroi 10a jusqu'à la paroi supérieure 7. Les premières parois 9a, 10a et les deuxièmes parois 9b, 10b sont ici conformées en plaques.

Dans le cas présent, les premières parois 9a, 10a s'étendent parallèlement entre elles. Optionnellement, les premières parois 9a, 10a s'étendent orthogonalement à la paroi inférieure 5.

Dans le cas présent, les deuxièmes parois 9b, 10b s'étendent selon une même inclinaison relativement à la première paroi associée mais selon des sens opposés de sorte que les deuxièmes parois 9b, 10b se rapprochent à mesure que l'on se rapproche de la paroi supérieure 7. La paroi supérieure 7 est donc d'une longueur (selon l'axe X) moins importante que la paroi inférieure 5. Les premières parois 9a, 10a des flancs latéraux 8 ne sont pas nécessairement de la même hauteur (selon l'axe Z).

Optionnellement, le dissipateur 4 peut comporter au moins une languette d'assemblage à l'équipement électronique 100 et/ou à la platine 2 (en plus des patins 6). De préférence, la languette de liaison est portée par l'un des flancs latéraux 8 du dissipateur 4.

Dans l'exemple illustré et non limitatif, une première languette 11 s'étend depuis le flanc latéral droit 8 et une deuxième languette 12 s'étend depuis le flanc latéral gauche 8, les deux languettes 11, 12 s'étendant en direction opposée l'une de l'autre.

Le dissipateur 4 est par ailleurs creux.

Le dissipateur 4 est ainsi muni d'au moins une ouverture 13 le traversant de sorte à déboucher sur sa première face principale (face encadrée par les flancs latéraux 8, la paroi supérieure 7 et la paroi inférieure 5) et sur sa deuxième face principale (face encadrée par les flancs latéraux 8, la paroi supérieure 7 et la paroi inférieure 5 et qui s'étend ici parallèlement à la première face principale). De la sorte, lorsque le dissipateur 4 est agencé sur la platine 2, son ouverture 13 s'étend coaxialement à l'axe Y.

Si l'on retourne à l'ensemble des dissipateurs 4, les dissipateurs 4 sont agencés de sorte que leurs différentes parois supérieures 7 s'étendent toutes dans un même plan qui est ici parallèle aux axes X et Y.

De préférence, les dissipateurs 4 sont agencés de sorte que leurs différentes parois inférieures 5 s'étendent toutes dans un même plan qui est ici parallèle aux axes X et Y.

De préférence, les premières parois 9a des flancs latéraux gauches 8 de tous les dissipateurs 4 et les premières parois 10a des flancs latéraux droits 8 de tous les dissipateurs 4 s'étendent toutes parallèlement entre elles et ici également au plan contenant les axes Y et Z.

De préférence, les deuxièmes parois 9b des flancs latéraux gauches 8 de tous les dissipateurs 4 s'étendent toutes parallèlement entre elles et ici également à un même plan incliné vis-à-vis du plan comprenant les axes Y et Z.

De préférence, les deuxièmes parois 10b des flancs latéraux droits 8 de tous les dissipateurs 4 s'étendent toutes parallèlement entre elles et ici également à un plan incliné vis-à-vis du plan comprenant les axes Y et Z.

Si extérieurement les dissipateurs 4 sont alignés, intérieurement les dissipateurs 4 ne sont pas tous identiques entre eux de sorte qu'au moins une des ouvertures 13 d'au moins un des dissipateurs 4 soit décalée d'au moins l'une des ouvertures 13 d'au moins un autre des dissipateurs 4.

Par exemple, les deux ouvertures 13 (identiques ou différentes en forme) sont décalées l'une par rapport à l'autre selon au moins une direction appartenant au plan parallèle aux faces principales des dissipateurs 4 et/ou décalées l'une par rapport à l'autre selon une direction parallèle à l'axe Z et/ou selon une direction parallèle à l'axe X. Par exemple, les ouvertures 13 sont décalées l'une de l'autre selon une direction parallèle à l'axe X.

Au moins une des ouvertures 13 est conformée pour présenter une section transversale (pour un plan de section parallèle aux faces principales du dissipateur) de forme rectangulaire, carré ou en trapèze.

Au moins une des ouvertures 13 est conformée pour présenter une section transversale dont au moins une dimension est supérieure à 4 millimètres et de préférence dont au moins une dimension est supérieure à 5 millimètres. Par exemple la largeur et/ou la longueur et/ou le diamètre de la section transversale de l'ouverture 13 est supérieure à 4 millimètres et de préférence supérieure à 5 millimètres.

De préférence, au moins un des dissipateurs 4 comprend un orifice central le traversant de sorte à déboucher sur les deux faces principales du dissipateur 4. De la sorte, lorsque le dissipateur 4 est agencé sur la platine 2 son orifice central s'étend coaxialement à l'axe Y.

Par ailleurs, le dissipateur 4 comporte au moins une cloison (appelée par la suite paroi interne) 14 agencée dans l'orifice central. Cette paroi interne 14 permettant de diviser l'orifice central en au moins deux ouvertures 13 telles que définies ci-dessus. La paroi interne 14 est ainsi commune aux deux orifices 13. Par exemple la paroi interne 14 s'étend parallèlement aux premières parois 9a, 10a des flancs latéraux 8 (soit parallèlement à l'axe Z lorsque le dissipateur 4 est en place sur la platine). Par exemple, la paroi interne 14 s'étend entre la paroi supérieure 7 et la paroi inférieure 5. Par exemple la paroi interne 14 présente une épaisseur identique à plus au moins 10%, et de préférence à plus ou moins 5%, à celle de la paroi supérieure 7 et/ou à celle de la paroi inférieure 5 et/ou à celle d'une des parois de l'un des flancs latéraux 8. Par exemple, la paroi interne 14 a une épaisseur comprise entre 1 et 3 millimètres.

On note que le dissipateur 4 permet de former à lui seul plusieurs ailettes par l'intermédiaire de sa paroi interne 14, de ses flancs latéraux 8, de sa paroi supérieure 7 et de sa paroi inférieure 5.

On note que le dissipateur 4 est de plus grandes dimensions qu'une simple ailette de l'art antérieur.

Optionnellement, le dissipateur 4 comporte au moins deux parois internes 14 agencées dans l'orifice central, parois internes 14 permettant de diviser l'orifice central en au moins trois ouvertures 13 telles que définies ci-dessus. Par exemple les parois internes 14 s'étendent parallèlement entre elles. Par exemple les parois internes 14 s'étendent parallèlement aux premières parois 9a, 10a des flancs latéraux 8 (soit parallèlement à l'axe Z lorsque le dissipateur 4 est en place sur la platine 2). Par exemple, les parois internes 14 s'étendent toutes entre la paroi supérieure 7 et la paroi inférieure 5. Par exemple les parois internes 14 sont identiques entre elles. Par exemple les parois internes 14 s'étendent entre les faces principales du dissipateur 4 - soit sur toute la largeur du dissipateur 4.

De préférence, tous les dissipateurs 4 comportent ici un orifice central dans lequel est agencée au moins une paroi interne 14 dessinant au moins deux ouvertures 13 dans le dissipateur concerné.

Par exemple toutes les parois internes 14 de tous les dissipateurs 4 s'étendent toutes parallèlement entre elles.

Par exemple toutes les parois internes 14 de tous les dissipateurs 4 s'étendent parallèlement aux premières parois 9a, 10a des flancs latéraux 8 (soit parallèlement à l'axe Z lorsque le dissipateur 4 est en place sur la platine 2).

Par exemple toutes les parois internes 14 de tous les dissipateurs 4 s'étendent entre les faces principales du dissipateur 4 associé - soit sur toute la largeur du dissipateur 4.

En revanche, entre au moins deux dissipateurs 4, le positionnement des parois internes 14 est différent et/ou le nombre de parois internes 14 et/ou la géométrie des parois internes 14 et/ou l'inclinaison des parois internes 14 est différente de sorte que les ouvertures 13 desdits deux dissipateurs 4 ne sont pas alignées entre elles.

De la sorte, lorsque les dissipateurs 4 sont installés sur la platine 2, les dissipateurs 4 s'étendent dans l'alignement les uns des autres selon l'axe Y et parallèlement entre eux avec un espacement selon l'axe Y entre deux dissipateurs 4 consécutifs. Néanmoins les parois internes 14 des dissipateurs 4 ne sont pas toutes alignées entre elles (selon une direction parallèle à l'axe Y ici) pour au moins deux dissipateurs 4 de sorte qu'au moins une paroi interne 14 de l'un des dissipateurs 4 se trouve alignée (selon une direction parallèle à l'axe Y ici) avec au moins une ouverture 13 de l'autre des dissipateurs 4.

Les au moins deux dissipateurs 4 concernés peuvent être conformés de sorte qu'une paroi interne 14 du premier dissipateur 4 soit décalée d'une paroi interne 14 du deuxième dissipateur 4 d'une distance (selon une direction parallèle à l'axe X) comprise entre 10 et 60% de la distance (selon une direction parallèle à l'axe X) séparant la paroi interne 14 du deuxième dissipateur 4 d'une autre paroi interne 14 (ou d'une paroi de l'un des flancs latéraux 8) du deuxième dissipateur 4 définissant avec la paroi interne du deuxième dissipateur 4 une ouverture 13 du deuxième dissipateur 4. De préférence, les au moins deux dissipateurs 4 concernés peuvent être conformés de sorte qu'une paroi interne 14 du premier dissipateur 4 soit décalée d'une paroi interne 14 du deuxième dissipateur 4 d'une distance (selon une direction parallèle à l'axe X) comprise entre 20 et 50% de la distance (selon une direction parallèle à l'axe X) séparant la paroi interne 14 du deuxième dissipateur 4 d'une autre paroi interne 14 (ou d'une paroi de l'un des flancs latéraux 8) du deuxième dissipateur 4 définissant avec la paroi interne 14 du deuxième dissipateur 4 une ouverture 13 du deuxième dissipateur 4. La paroi interne 14 du premier dissipateur 4 peut ainsi s'étendre en regard du milieu de l'ouverture 13 du deuxième dissipateur 4 ou à 1/5^{ème} cinquième de ladite ouverture 13 ou à un niveau intermédiaire entre le milieu et le 1/5^{ème} de ladite ouverture 13.

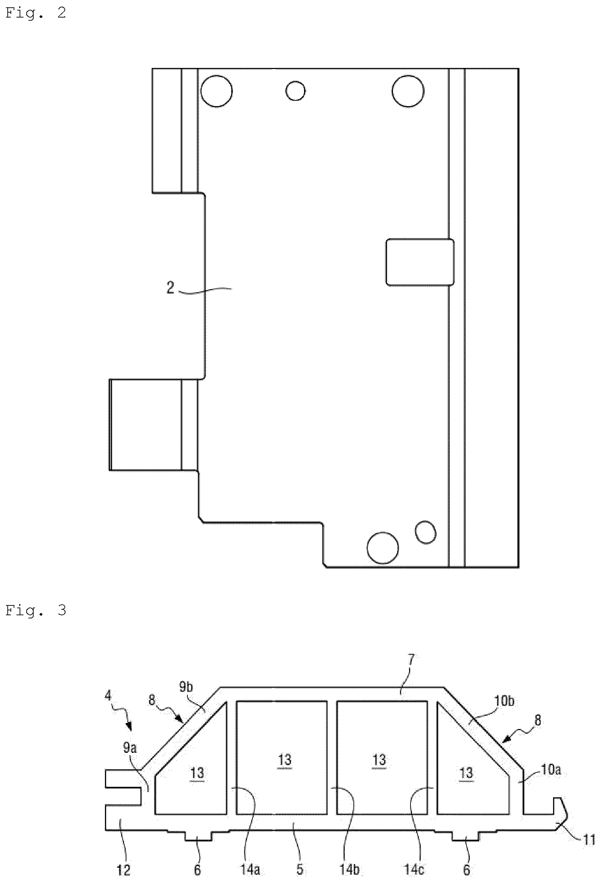

Par exemple le premier dissipateur 4 représenté à la figure 3 comprend :
- une première paroi interne 14a qui s'étend à la jonction entre la paroi supérieure 7 et la deuxième paroi 9b du flanc latéral gauche 8 jusqu'à la paroi inférieure 5,
- une deuxième paroi interne 14b qui s'étend à la jonction entre la paroi supérieure 7 et une deuxième paroi 10b du flanc latéral droit 14c jusqu'à la paroi inférieure 5,
- une troisième paroi interne 14c qui s'étend entre la paroi inférieure 5 et la paroi supérieure 7 à équidistance entre lesdites parois.

Les parois internes 14a, 14b, 14c du premier dissipateur 4 sont ainsi réparties à intervalles réguliers le long de la paroi supérieure 7. Les parois internes 14a, 14b, 14c du premier dissipateur 4 ont ainsi la même hauteur. Les parois internes 14a, 14b, 14c définissent ainsi quatre ouvertures 13 dans l'orifice central.

Par exemple, le deuxième dissipateur comprend :
- une première paroi interne qui s'étend entre une deuxième paroi 9b du flanc latéral gauche 8 et la paroi inférieure 5,
- une deuxième paroi interne qui s'étend entre la deuxième paroi 10b du flanc latéral droit 8 et la paroi inférieure 5,
- une troisième paroi interne qui s'étend entre la paroi inférieure 5 et la paroi supérieure 7.

Les parois internes 14 du deuxième dissipateur 4 n'ont donc pas toutes la même hauteur.

En service, la chaleur diffusée par l'équipement électronique 100 est transmise à la platine 2 (par conduction, par convection ...) qui les transmet à son tour aux dissipateurs 4 (par conduction, par convection ...).

Les dissipateurs 4 permettent alors de transférer les calories associés avec un écoulement d'air (forcé ou naturel) circulant dans l'appareil en traversant les ouvertures des dissipateurs 4. Par exemple, si l'appareil 1 est agencé à la verticale (l'axe Y s'étendant alors à la verticale et les deux axes X et Z à l'horizontal), l'air chaud ayant tendance à monter, l'écoulement d'air va partir de l'un des bords latéraux de la platine 2 pour remonter le long de la platine 2 selon une direction globalement verticale pour atteindre l'autre bord latéral.

De par le décalage entre les ouvertures 13, celles-ci créent des turbulences dans l'écoulement d'air qui ne peut s'écouler linéairement. Ceci permet d'augmenter les échanges thermiques entre l'appareil 1 et l'écoulement d'air.

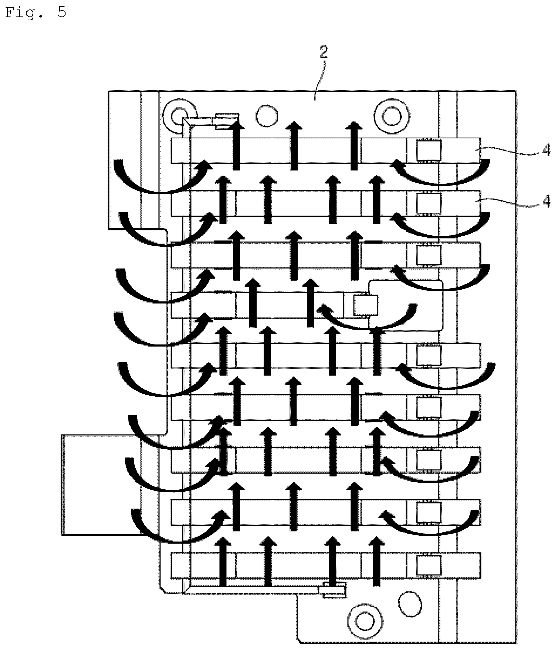

Comme visible à la figure 5, l'écoulement d'air ne suit donc pas une direction linéaire de par la présence d'obstacles sur son chemin. En effet, les parois internes 14 (les obstacles) des dissipateurs 4 se trouvent alignées avec des ouvertures 13 des autres dissipateurs 4, les parois internes 14 n'étant pas ici toutes parallèles entre elles.

Dès lors, l'écoulement d'air va devoir se diviser et/ou se réorienter puis se recombiner en plusieurs flux d'air au passage d'un, de plusieurs ou de tous les dissipateurs 4. En particulier, les ouvertures 14 ne sont pas coaxiales.

Ceci entraine des turbulences dans l'écoulement d'air ce qui favorise les échanges thermiques entre les dissipateurs 4 et l'écoulement d'air et favorise ainsi l'évacuation de la chaleur générée par l'équipement électronique 100.

L'appareil 1 permet ainsi efficacement d'évacuer ladite chaleur.

De façon avantageuse, le fait que deux dissipateurs 4 successifs soient espacés (selon l'axe Y) permet à des flux d'air supplémentaires de pénétrer l'appareil via les côtés de l'appareil 1 et ainsi de se mélanger à l'écoulement d'air général. Les flux d'air supplémentaires arrivent ainsi de manière oblique ou orthogonal à l'écoulement général (sous-divisés ici en plusieurs flux d'air de par la présence des parois internes 14).

Ceci permet non seulement d'apporter de l'air frais mais également d'amplifier les turbulences.

L'évacuation de la chaleur générée par l'équipement électronique 100 s'avère ainsi encore augmentée.

De préférence, chaque dissipateur 4 est différent du dissipateur 4 immédiatement amont et du dissipateur 4 immédiatement aval. Dans le cas présent, chaque dissipateur 4 comporte au moins une ouverture 13 décalée (selon l'axe Y) d'au moins une ouverture 13 du dissipateur 4 immédiatement amont et d'au moins une ouverture 13 du dissipateur 4 immédiatement aval. De la sorte, chaque dissipateur 4 comporte au moins une paroi interne 14 agencée dans le prolongement d'au moins une ouverture 13 du dissipateur 4 immédiatement amont et d'au moins une ouverture du dissipateur 4 immédiatement aval.

Ceci permet d'augmenter encore davantage la turbulence générée dans l'écoulement d'air.

On note que la platine 2 permet de répondre à des contraintes mécaniques (fixation sur l'équipement électronique 1, port des dissipateurs, fixation ou ports d'autres pièces ...) ainsi qu'à des contraintes thermiques en venant en particulier faire la liaison thermique entre l'équipement électronique 100 et les dissipateurs 4.

On note que les dissipateurs 4 ont pour but de générer des turbulences dans l'écoulement d'air. L'appareil 1 de régulation thermique selon le premier mode de réalisation comporte en effet un décalage des parois internes 14 (formant ici des ailettes) des dissipateurs 4 selon une direction parallèle à l'axe X et donc un décalage correspondant des ouvertures 13.

De façon avantageuse, on note également que tous les dissipateurs 4 n'ont pas besoin d'être tous différents entre eux pour engendrer des turbulences. En effet, l'appareil 1 peut comprendre au moins un premier groupe de dissipateurs 13 identiques entre eux et au moins un deuxième groupe de dissipateurs 13 identiques entre eux mais différents de ceux du premier groupe pour générer une turbulence dans l'écoulement d'air à travers l'appareil 1 lors du positionnement des dissipateurs 4 sur la platine 2. De préférence, les dissipateurs 4 sont alors agencés de sorte à alterner sur au moins une zone de l'appareil 1 un dissipateur 4 du premier groupe avec successivement un dissipateur 4 du deuxième groupe (selon ici l'axe Y).

Par exemple on peut avoir au moins un premier groupe de dissipateurs 4 identiques entre eux, un deuxième groupe de dissipateurs 4 identiques entre eux mais différents de ceux du premier groupe et un troisième groupe de dissipateurs 4 identiques entre eux mais différents de ceux du premier groupe et différents de ceux du deuxième groupe afin de générer une turbulence dans l'écoulement d'air à travers l'appareil 1 lors du positionnement des dissipateurs 4 sur la platine 2. De préférence, les dissipateurs 4 sont alors agencés de sorte à alterner sur au moins une zone de l'appareil 1 successivement un dissipateur 4 du premier groupe, un dissipateur 4 du deuxième groupe, un dissipateur 4 du troisième groupe (selon ici l'axe Y). L'appareil 1 peut ainsi comporter entre 2 et 6 groupes de dissipateurs 4 (dissipateurs 4 identiques au sein d'un même groupe mais différents entre deux groupes) et par exemple entre 3 et 4 groupes de dissipateurs thermiques.

Un tel appareil 1 peut avantageusement être fabriqué de multiples façons.

Par exemple la platine 2 peut être une platine extrudée ou injectée.

Indépendamment du mode de fabrication de la platine 2, les dissipateurs 4 peuvent être extrudés ou injectés. Il est également possible d'avoir une partie des dissipateurs 4 extrudés et une partie des dissipateurs 4 injectés.

L'assemblage des dissipateurs 4 sur la platine 2 peut également se faire de multiples façons, par exemple par soudage, par assemblage en force, par vissage, par clipsage, par bridage, par collage, par l'intermédiaire d'adhésif ou de colle, par clinchage ...

De manière avantageuse, les dissipateurs 4 et/ou la platine 2 peuvent être fabriqués à partir de nombreux matériaux et par exemple à partir d'un ou de plusieurs alliages métalliques et par exemple à partir d'au moins un alliage d'aluminium et/ou à partir d'au moins un alliage de cuivre, et/ou à partir d'au moins une matière plastique. Au moins un des dissipateurs 4 peut être dans le même matériau que la platine ou au contraire être dans un matériau différent. De plus, un tel appareil 1 peut aisément être fabriqué en grandes séries. En effet, les dissipateurs 4 sont d'une forme simple. En outre comme indiqué ci-dessus, tous les dissipateurs 4 d'un même appareil n'ont pas besoin d'être tous différents entre eux. Il est donc possible de définir que quelques modèles de dissipateurs 4, qui sont ensuite fabriqués à grandes échelles. C'est le positionnement alterné des différents modèles de dissipateurs 4 qui permettra de créer des décalages dans les ouvertures 13.

Par exemple, on peut fabriquer au moins deux profilés de géométries différentes et découper chacun des profilés de sorte à former un premier groupe de dissipateurs 4 et un deuxième groupe de dissipateurs 4 différents des premiers. La fabrication des profilés est ainsi simple et rapide.

Un procédé de fabrication d'un tel appareil 1 va être à présent décrit.

Dans une première étape, on fabrique la platine 2 (par extrusion, par injection ...). De préférence on fabrique la platine 2 de sorte qu'elle réponde à différentes contraintes liées à l'équipement électronique 100 associé (contraintes mécaniques, thermiques, radio, matériel ou « hardware » ...).

Dans une deuxième étape, on identifie parmi les composants portés par l'équipement électronique 100, qui est ou sera en regard de la platine 2, ceux qui vont dégager le plus de chaleur et/ou ceux qui sont les plus sensibles à la chaleur. On identifie ainsi les zones clés de la platine 2.

Dans une troisième étape, on fabrique les dissipateurs 4 (par extrusion, par injection ...) en fonction de ces zones clés (positionnements et/ou nombres et/ou étendues et/ou nombre de calories à évacuer).

Dans une quatrième étape, on assemble les dissipateurs 4 sur la platine 2 de sorte à positionner les dissipateurs 4 de préférence en face des zones clés. On comprend donc que les caractéristiques des zones clés (dimensions, nombre, localisations, nombre de calories à évacuer ...) permettent de caractériser les dissipateurs 4 (par exemple permettent de les dimensionner et par exemple de dimensionner leurs épaisseurs - selon l'axe Y) et de les positionner.

De préférence, en plus des dissipateurs 4 agencés en regard des interfaces thermiques, un ou plusieurs autres dissipateurs 4 peuvent être agencés sur la platine 2 afin de perturber davantage l'écoulement de l'air le long de la platine 2.

Par exemple dans le cas où l'appareil 1 est agencé à la verticale (l'axe Y s'étendant alors à la verticale), avec un écoulement d'air naturel, l'air chaud va avoir tendance à monter de sorte que l'air va naturellement s'écouler le long de l'axe Y de bas en haut. Il est donc préférable de placer les parois internes sur cet axe pour gêner son déplacement. L'épaisseur des dissipateurs 4 (et donc des parois internes), définie selon l'axe Y, s'étend ainsi parallèlement à l'écoulement d'air. En revanche l'épaisseur des parois internes (selon l'axe X) s'étend ici orthogonalement à l'écoulement d'air.

Par exemple, avec un écoulement d'air forcé, il est préférable de placer les parois internes sur l'axe de circulation de l'écoulement d'air forcé. De préférence, on agence alors les dissipateurs 4 de sorte que l'épaisseur des dissipateurs 4 (et donc des parois internes), définie selon l'axe Y, s'étend ainsi parallèlement à l'écoulement d'air. En revanche l'épaisseur des parois internes (selon l'axe X) s'étend ici orthogonalement à l'écoulement d'air. On a ainsi décrit un mode de réalisation permettant de générer des turbulences au sein d'un écoulement d'air traversant les dissipateurs 4 grâce à une géométrie différente des dissipateurs.

Bien entendu d'autres modes de réalisation de l'invention sont possibles.

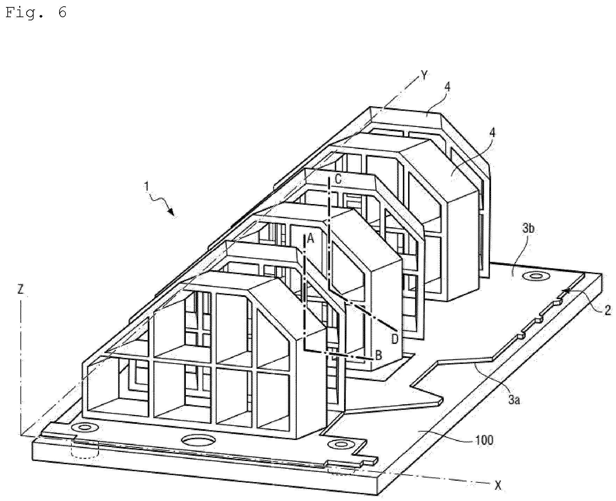

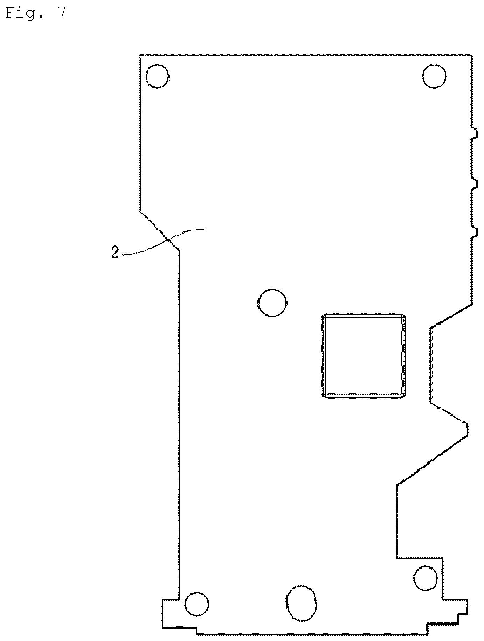

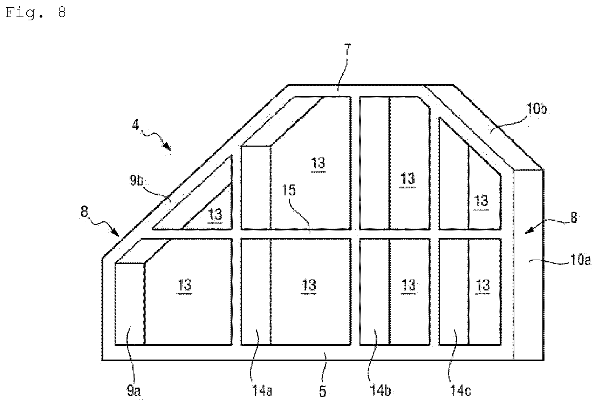

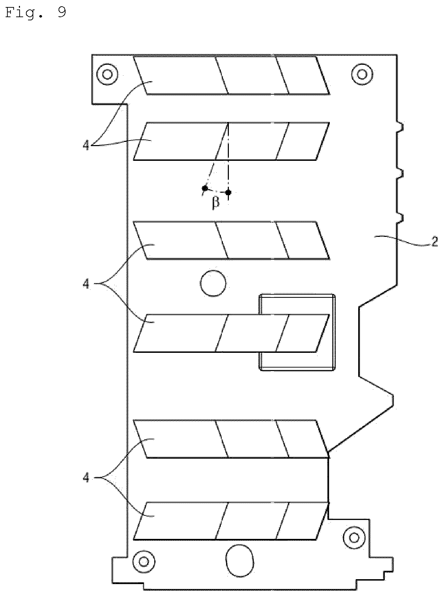

Ainsi, en référence aux figures 6 à 10, selon un deuxième mode de réalisation de l'invention, les parois internes 14 des dissipateurs ne sont pas agencées parallèlement entre elles. Au moins deux parois internes 14 de dissipateurs 4 différents sont agencées de manière inclinée l'un par rapport à l'autre. Ceci force l'air à suivre un chemin non linéaire et ainsi à engendrer de la turbulence dans l'écoulement d'air. On comprend en effet que les ouvertures 13 des dissipateurs 4 en question sont décalées angulairement les unes par rapport aux autres.

Le deuxième mode de réalisation va être à présent détaillé ci-dessous.

L'appareil 1 de régulation thermique est associé à un équipement électronique 100 afin de réguler thermiquement ledit équipement électronique 100. L'équipement électronique 100 est par exemple une carte électronique telle qu'une carte à circuit imprimés.

L'appareil 1 comprend une platine 2 qui est conformée en une plaquette. La platine 2 présente ainsi une épaisseur bien moins importante que ses autres dimensions. La platine 2 présente ainsi deux faces principales : une première face principale 3a et une deuxième face principale 3b.

L'appareil 1 est agencé de sorte que la première face principale 3a s'étende en regard d'une des faces de l'équipement électronique 100. Dans le cas présent, la première face principale 3a s'étend en regard d'une des faces principales de l'équipement électronique 100. De préférence, l'appareil 1 est agencé de sorte que la première face principale 3a s'étende parallèlement à l'une des faces principales de l'équipement électronique 100.

La platine 2 est ici fixée à l'équipement électronique 100. La platine 2 est ainsi apposée sur l'équipement électronique 100 et se trouve en contact avec au moins une zone de l'équipement électronique 100.

La liaison entre la platine 2 et l'équipement électronique 100 est similaire à celle d'une semelle d'un appareil de régulation thermique de l'art antérieur et ne sera donc pas détaillée ici.

L'appareil 1 comporte par ailleurs une pluralité de dissipateurs 4 rapportés sur la deuxième face principale 3b de la platine 2. L'appareil 1 comprend par exemple entre 2 et 12 dissipateurs thermiques 4 et par exemple entre 2 et 9 dissipateurs thermiques 4.

Les différents dissipateurs 4 sont rapportés sur la platine 2 de sorte à s'étendre ici parallèlement les uns aux autres. Par exemple les dissipateurs 4 sont agencés de sorte à s'étendre parallèlement aux bords latéraux de la platine 2 qui s'étendent eux-mêmes parallèlement à un axe X. La deuxième face principale 3b est ainsi définie par un plan contenant l'axe X et un axe Y orthogonal à l'axe X.

Les dissipateurs 4 sont par ailleurs rapportés sur la platine 2 de sorte à s'étendre les uns à la suite des autres selon l'axe Y. Par exemple la distance (selon l'axe Y) entre deux dissipateurs 4 successifs est supérieure à 4 millimètres et par exemple supérieure à 5 millimètres. Par exemple la distance (selon l'axe Y) entre deux dissipateurs 4 successifs est inférieure à 50 millimètres et par exemple inférieure à 40 millimètres. Optionnellement, l'intervalle entre deux dissipateurs 4 successifs est le même sur toute la longueur (selon l'axe Y) de la deuxième face principale 3b.

Les dissipateurs 4 sont par ailleurs agencés sur la platine 2 de sorte que leur largeur s'étende ici de manière inclinée relativement à l'axe Y et leur longueur s'étende parallèlement à l'axe X.

Chaque dissipateur 4 présente deux faces principales s'étendant parallèlement entre elles. Ici, chaque dissipateur 4 est conformé de sorte que ses deux faces principales s'étendent parallèlement à un plan contenant l'axe X et un axe Z qui est orthogonal à l'axe X et à l'axe Y (l'épaisseur de la platine 2 étant définie le long de cet axe Z).

On va à présent décrire l'un des dissipateurs 4, la description qui suit s'appliquant également aux autres dissipateurs 4 dans le cas présent.

Le dissipateur 4 est formé de plusieurs parois, chaque paroi étant conformée en une plaquette. Le dissipateur 4 est toutefois de préférence d'une seule pièce. De préférence, les différentes parois formant le dissipateur 4 ont une épaisseur comprise entre 1 et 3 millimètres. Au moins deux parois d'un même dissipateur 4 peuvent optionnellement avoir la même épaisseur.

Le dissipateur 4 présente une paroi inférieure 5 montée en regard de la platine 2 et optionnellement parallèlement à la deuxième face principale 3b. La paroi inférieure 5 s'étend ainsi dans un plan parallèle aux axes X et Y. La paroi inférieure 5 est conformée en une plaque.

La paroi inférieure 5 est optionnellement munie d'au moins une patte et par exemple d'au moins deux pattes par l'intermédiaire desquelles le dissipateur 4 repose sur la platine 2.

Les contacts entre le dissipateur 4 et la platine 2 sont ainsi de faibles dimensions.

Le dissipateur 4 comporte par ailleurs optionnellement au moins une paroi supérieure 7 agencée au-dessus de la paroi inférieure 5 et s'étendant optionnellement parallèlement à la paroi inférieure 5. La paroi supérieure 7 s'étend ainsi dans un plan parallèle aux axes X et Y. La paroi supérieure 7 est conformée en une plaque.

Le dissipateur 4 comporte par ailleurs des flancs latéraux 8 pour relier les parois inférieure 5 et supérieure 7 entre elles.

Par exemple le flanc latéral gauche 8 comporte une première paroi 9a et une deuxième paroi 9b, la première paroi 9a s'étendant depuis la paroi inférieure 5 jusqu'à la deuxième paroi 9b et la deuxième paroi 9b s'étendant depuis la première paroi 9a jusqu'à la paroi supérieure 7. De même le flanc latéral droit 8 comporte une première paroi 10a et une deuxième paroi 10b, la première paroi 10a s'étendant depuis la paroi inférieure 5 jusqu'à la deuxième paroi 10b et la deuxième paroi 10a s'étendant depuis la première paroi 10a jusqu'à la paroi supérieure 7. Les premières parois 10a et les deuxièmes parois 10b sont ici conformées en plaques.

Dans le cas présent, les premières parois 10a s'étendent parallèlement entre elles.

Dans le cas présent, les deuxièmes parois 10b s'étendent selon une même inclinaison relativement à la première paroi 10a associée mais selon des sens opposés de sorte que les deuxièmes parois 10b se rapprochent à mesure que l'on se rapproche de la paroi supérieure 7. La paroi supérieure 7 est donc d'une longueur (selon l'axe X) moins importante que la paroi inférieure 5. Optionnellement, le dissipateur 4 peut comporter au moins une languette de liaison à l'équipement électronique 100 et/ou à la platine 2 (en plus des patins). De préférence, la languette de liaison est portée par l'un des flancs latéraux 8 du dissipateur.

Le dissipateur 4 est par ailleurs creux.

Le dissipateur 4 est ainsi muni d'au moins une ouverture 13 le traversant de sorte à déboucher sur sa première face principale (face encadrée par les flancs latéraux 8, la paroi supérieure 7 et la paroi inférieure 5) et sur sa deuxième face principale (face encadrée par les flancs latéraux 8, la paroi supérieure 7 et la paroi inférieure 5 et qui s'étend ici parallèlement à la première face principale). Si l'on retourne à l'ensemble des dissipateurs 4, les dissipateurs 4 sont agencés de sorte que leurs différentes parois supérieures 7 s'étendent toutes dans un même plan qui est ici parallèle aux axes X et Y.

De préférence, les dissipateurs 4 sont agencés de sorte que leurs différentes parois inférieures 5 s'étendent toutes dans un même plan qui est ici parallèle aux axes X et Y.

De préférence, les premières parois 9a des flancs latéraux gauches 8 de tous les dissipateurs 4 et les premières parois 10a des flancs latéraux droits 8 de tous les dissipateurs 4 ne s'étendent pas toutes parallèlement entre elles. Les premières parois 9a des flancs latéraux gauches 8 de tous les dissipateurs 4 et les premières parois 10a des flancs latéraux droits de tous les dissipateurs 4 s'étendent par ailleurs de manière incliné relativement au plan contenant les axes Y et Z.

De préférence, les deuxièmes parois 9b des flancs latéraux gauches 8 de tous les dissipateurs 4 ne s'étendent pas toutes parallèlement entre elles. Les deuxièmes parois 9b des flancs latéraux gauches 8 de tous les dissipateurs s'étendent toutes de manière incliné vis-à-vis du plan comprenant les axes Y et Z.

De préférence, les deuxièmes parois 10b des flancs latéraux droits 8 de tous les dissipateurs 4 ne s'étendent pas toutes parallèlement entre elles. Les deuxièmes parois 10b des flancs latéraux droits 8 de tous les dissipateurs 4 s'étendent toutes de manière incliné vis-à-vis du plan comprenant les axes Y et Z.

Au moins une des ouvertures 13 d'au moins un des dissipateurs 4 est par ailleurs décalée angulairement d'au moins l'une des ouvertures 13 d'au moins un autre des dissipateurs 4.

Par exemple, les deux ouvertures 13 (identiques ou différentes en forme) sont décalées angulairement l'une par rapport : l'une présentant une section transversale dans un plan contenant un axe A parallèle à l'axe Z et un axe B incliné relativement à l'axe X et l'autre présentant une section transversale s'étendant dans un plan contenant un axe C parallèle à l'axe Z et un axe D incliné relativement à l'axe X. Les axes A et C s'étendent donc parallèlement entre eux. De préférence, les axes B et D s'étendent avec un même angle d'inclinaison vis-à-vis de l'axe X (en valeur absolue) mais selon des signes opposés. Ainsi une paroi interne 14 d'un premier dissipateur 4 est inclinée vis-à-vis des faces principales du premier dissipateur 4 et une paroi interne 14 du deuxième dissipateur 4 est également inclinée vis-à-vis des faces principales du deuxième dissipateur 4 selon la même valeur d'angle d'inclinaison mais avec un signe opposé d'angle d'inclinaison. Les parois interne 14 dessinent donc un zigzag entre les deux dissipateurs 4.

Au moins une des ouvertures 13 est conformée pour présenter une section transversale (soit pour un plan de section parallèle aux faces principales du dissipateur 4) de forme rectangulaire, carré ou en trapèze.

Au moins une des ouvertures 13 est conformée pour présenter une section transversale dont au moins une dimension est supérieure à 4 millimètres et de préférence dont au moins une dimension est supérieure à 5 millimètres. Par exemple la largeur et/ou la longueur et/ou le diamètre de la section transversale de l'ouverture 13 est supérieure à 4 millimètres et de préférence supérieure à 5 millimètres.

De préférence, au moins un des dissipateurs 4 comprend un orifice central le traversant de sorte à déboucher sur les deux faces principales du dissipateur 4.

Par ailleurs, le dissipateur 4 comporte au moins une cloison (appelée par la suite paroi interne) 14 agencée dans l'orifice central. La paroi interne 14 permettant de diviser l'orifice central en au moins deux ouvertures 13 telles que définies ci-dessus. La paroi interne 14 est ainsi commune aux deux ouvertures 13.

Par exemple la paroi interne 14 s'étend parallèlement et/ou orthogonalement et/ou de manière inclinée aux premières parois 9a, 10a des flancs latéraux 8. Par exemple, la paroi interne 14 s'étend entre la paroi supérieure 7 et la paroi inférieure 5 ou s'étend entre les deux flancs latéraux 8. Par exemple la paroi interne 14 présente une épaisseur identique à plus au moins 10%, et de préférence à plus ou moins 5%, à celle de la paroi supérieure 7 et/ou à celle de la paroi inférieure 5 et/ou à celle d'une des parois de l'un des flancs latéraux 8. Par exemple, la paroi interne 14 a une épaisseur comprise entre 1 et 3 millimètres.

On note que le dissipateur 4 permet de former à lui seul plusieurs ailettes par l'intermédiaire de sa paroi interne 14, de ses flancs latéraux 8, de sa paroi supérieure 7 et de sa paroi inférieure 5.

On note que le dissipateur 4 est de plus grandes dimensions qu'une simple ailette de l'art antérieur.

Optionnellement, le dissipateur 4 comporte au moins deux parois internes 14 agencées dans l'orifice central, parois internes 14 permettant de diviser l'orifice central en au moins trois ouvertures 13 telles que définies ci-dessus. Par exemple les parois internes 14 s'étendent parallèlement et/ou orthogonalement et/ou de manière inclinée entre elles. Par exemple au moins une paroi interne 14 s'étend parallèlement aux premières parois 10, 9a des flancs latéraux 8 et au moins une deuxième paroi interne 14 s'étend orthogonalement aux premières parois 9a, 10a des flancs latéraux 8. Par exemple les parois internes 14 s'étendent entre les faces principales du dissipateur 4 - soit sur toute la largeur du dissipateur 4.

Par ailleurs, entre au moins deux dissipateurs 4, l'inclinaison des parois internes 14 est différente de sorte que les ouvertures 13 desdits deux dissipateurs 4 ne sont pas alignées entre elles. De la sorte, lorsque les dissipateurs 4 sont installés sur la platine 2, les dissipateurs 4 s'étendent dans l'alignement les uns des autres selon l'axe Y et parallèlement entre eux avec un espacement selon l'axe Y entre deux dissipateurs 4 consécutifs. Néanmoins les parois internes 14 des dissipateurs 4 ne sont pas toutes alignées entre elles (selon une direction parallèle à l'axe Y ici) pour au moins deux dissipateurs 4 de sorte qu'au moins une paroi interne 14 de l'un de dissipateurs 4 se trouve alignée (selon une direction parallèle à l'axe Y ici) avec au moins une ouverture 13 de l'autre des dissipateurs.

Les au moins deux dissipateurs 4 concernés peuvent être conformés de sorte qu'une paroi interne 14 du premier dissipateur 4 soit décalée angulairement d'une paroi interne 14 du deuxième dissipateur. Par exemple, au moins une des parois internes 14 du premier dissipateur 4 et/ou au moins une des parois internes 14 du deuxième dissipateur 4 est inclinée d'un angle β d'un plan comprenant les axes Y et Z, angle β compris entre 5 et 35 degrés et par exemple compris entre 10 et 30 degrés.

Par exemple le premier dissipateur 4 comprend :
- une première paroi interne 14a qui s'étend entre la deuxième paroi 9b du flanc latéral gauche 8 jusqu'à la paroi inférieure 5,
- une deuxième paroi interne 14b qui s'étend entre la deuxième paroi 10b du flanc latéral droit 8 jusqu'à la paroi inférieure 5,
- une troisième paroi interne 14c qui s'étend entre la paroi inférieure 5 et la paroi supérieure 7 à équidistance entre lesdites parois,
- une quatrième paroi interne 15 qui s'étend entre les flancs latéraux 8.

De la sorte, le premier dissipateur 4 comporte huit ouvertures 13 réparties sur deux étages (la quatrième paroi interne 15 délimitant lesdits deux étages).

La quatrième paroi interne 15 est par exemple parallèle aux parois inférieure 5 et supérieure 7 (et donc inclinée ici vis-à-vis des flancs latéraux 8). Les trois premières parois internes 14a, 14b, 14c sont par ailleurs parallèles aux premières parois 9a, 10a des flancs latéraux 8 (et donc inclinées vis-à-vis des parois supérieure 7 et inférieure 5).

Par exemple, le deuxième dissipateur 4 est identique au premier dissipateur 4 mis à part le fait que ses trois premières parois 14 sont inclinées vis-à-vis des parois inférieure 5 et supérieure 7 avec un même angle en valeur absolue relativement aux parois inférieure 5 et supérieure 7 mais avec un signe différent.

En service, la chaleur diffusée par l'équipement électronique 100 est transmise à la platine 2 (par conduction, par convection ...) qui les transmet à son tour aux dissipateurs 4 (par conduction, par convection ...).

Les dissipateurs 4 permettent alors de transférer les calories associés avec un écoulement d'air (forcé ou naturel) circulant dans l'appareil 1 en traversant les ouvertures 13 des dissipateurs 4. Par exemple, si l'appareil 1 est agencé à la verticale (l'axe Y s'étendant alors à la verticale et les deux axes X et Z à l'horizontal), l'air chaud ayant tendance à monter, l'écoulement d'air va partir de l'un des bords latéraux de la platine 2 pour remonter le long de la platine 2 selon une direction globalement verticale pour atteindre l'autre bord latéral.

De par le décalage angulaire entre les ouvertures 13, celles-ci créent des turbulences dans l'écoulement d'air qui ne peut s'écouler linéairement, les ouvertures 13 l'obligeant à modifier sa direction d'écoulement d'un dissipateur 4 à un autre. Ceci permet d'augmenter les échanges thermiques entre l'appareil 1 et l'écoulement d'air.

On comprend donc que les ouvertures 13 d'au moins deux dissipateurs 4 ne sont pas coaxiales et forcent un écoulement d'air passant par l'une des ouvertures 13 à dévier d'une trajectoire purement linéaire.

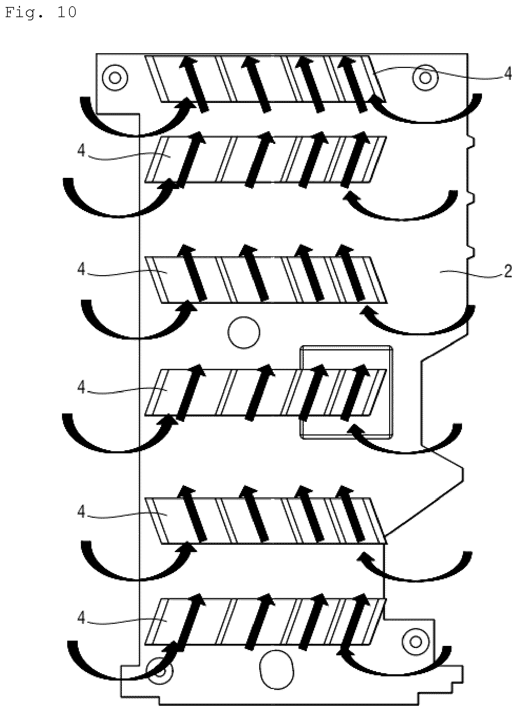

Comme visible à la figure 10, l'écoulement d'air ne suit donc pas une direction linéaire de par la présence d'obstacles sur son chemin. En effet, les parois internes 14 (les obstacles) des dissipateurs 4 se trouvent alignées avec des ouvertures 13 des autres dissipateurs 4, les parois internes 14 n'étant pas toutes parallèles entre elles. Dès lors, l'écoulement d'air va devoir se diviser et/ou se réorienter puis se recombiner en plusieurs flux d'air au passage d'un, de plusieurs ou de tous les dissipateurs 4. En particulier, les ouvertures 13 ne sont pas coaxiales.

Ceci entraine des turbulences dans l'écoulement d'air ce qui favorise les échanges thermiques entre les dissipateurs 4 et l'écoulement d'air et favorise ainsi l'évacuation de la chaleur générée par l'équipement électronique 100.

En particulier, les parois internes 14 sont décalées d'un certain angle par rapport à l'écoulement d'air ce qui vient le rediriger. En inversant l'angle d'inclinaison des parois internes 14 d'un dissipateur 4 à un autre (de préférence entre chaque couple successif de dissipateurs 4 de l'appareil 1), l'écoulement d'air zig-zague le long de l'appareil 1.

L'appareil 1 permet ainsi efficacement d'évacuer ladite chaleur.

De façon avantageuse, le fait que deux dissipateurs 4 successifs soient espacés (selon l'axe Y) permet à des flux d'air supplémentaires de pénétrer l'appareil 1 via les côtés de l'appareil 1 et ainsi de se mélanger à l'écoulement d'air général. Les flux d'air supplémentaires arrivent ainsi de manière oblique ou orthogonal à l'écoulement général (sous-divisés ici en plusieurs flux d'air de par la présence des parois internes 14).

Ceci permet non seulement d'apporter de l'air frais mais également d'amplifier les turbulences.

L'évacuation de la chaleur générée par l'équipement électronique 100 s'avère ainsi encore augmentée.

De préférence, les parois internes 14 d'un dissipateur 1 sont inclinées différemment des parois internes 14 du dissipateur 1 immédiatement amont et du dissipateur 1 immédiatement aval. Dans le cas présent, chaque dissipateur 1 comporte au moins une ouverture 13 décalée (angulairement d'au moins une ouverture 13 du dissipateur 4 immédiatement amont et d'au moins une ouverture 13 du dissipateur 4 immédiatement aval. De la sorte, chaque dissipateur 4 comporte au moins une paroi interne 14 agencée dans le prolongement d'au moins une ouverture 13 du dissipateur immédiatement amont et d'au moins une ouverture 13 du dissipateur immédiatement aval.

Ceci permet d'augmenter encore davantage la turbulence générée dans l'écoulement d'air.

On note que la platine 2 permet de répondre à des contraintes mécaniques (fixation sur l'équipement électronique 100, port des dissipateurs 4, fixation ou ports d'autres pièces ...) ainsi qu'à des contraintes thermiques en venant en particulier faire la liaison thermique entre l'équipement électronique 100 et les dissipateurs 4.

On note que les dissipateurs 4 ont pour but de générer des turbulences dans l'écoulement d'air. L'appareil 1 de régulation thermique selon le deuxième mode de réalisation comporte en effet un décalage angulaires des parois internes 14 (formant ici des ailettes) des dissipateurs 4 et donc un décalage correspond des ouvertures 13.

De façon avantageuse, on note également que tous les dissipateurs 4 n'ont pas besoin d'être tous différents entre eux pour engendrer des turbulences. En effet, l'appareil 1 peut comprendre au moins un premier groupe de dissipateurs 4 identiques entre eux et au moins un deuxième groupe de dissipateurs 4 identiques entre eux mais différents des dissipateurs 4 du premier groupe pour générer une turbulence dans l'écoulement d'air à travers l'appareil 1 lors du positionnement des dissipateurs 4 sur la platine 2. De préférence, les dissipateurs 4 sont alors agencés de sorte à alterner sur au moins une zone de l'appareil 1 un dissipateur 4 du premier groupe avec successivement un dissipateur 4 du deuxième groupe (selon ici l'axe Y). L'appareil 1 peut ainsi comporter entre 2 et 6 groupes de dissipateurs 4 (dissipateurs 4 identiques au sein d'un même groupe mais différents entre deux groupes) et par exemple entre 3 et 4 groupes de dissipateurs thermiques.

De façon avantageuse, tous les dissipateurs 4 peuvent être identiques entre eux avant d'être assemblés sur la platine 2. En effet, il suffit alors de modifier l'orientation relative des dissipateurs 4 sur la platine 2 pour orienter les parois internes 14 entre deux dissipateurs 4 de manière différente. Par exemple, il suffit d'agencer un premier dissipateur 4 et d'agencer un deuxième dissipateur 4 en le retournant vis-à-vis du premier dissipateur 4 pour obtenir un décalage angulaire entre les parois internes 14 desdits deux dissipateurs 4.

Un tel appareil 1 peut avantageusement être fabriqué de multiples façons.

Par exemple la platine 2 peut être une platine extrudée ou injectée.

Indépendamment du mode de fabrication de la platine 2, les dissipateurs 4 peuvent être extrudés ou injectés. Il est également possible d'avoir une partie des dissipateurs 4 extrudés et une partie des dissipateurs 4 injectés.

L'assemblage des dissipateurs 4 sur la platine 2 peut également se faire de multiples façons, par exemple par soudage, par assemblage en force, par vissage, par clipsage, par bridage, par collage, par l'intermédiaire d'adhésif ou de colle, par clinchage ...

De manière avantageuse, les dissipateurs 4 et/ou la platine 2 peuvent être fabriqués à partir de nombreux matériaux et par exemple à partir d'un ou de plusieurs alliages métalliques et par exemple à partir d'au moins un alliage d'aluminium et/ou à partir d'au moins un alliage de cuivre, et/ou à partir d'au moins une matière plastique. Au moins un des dissipateurs 4 peut être dans le même matériau que la platine 2 ou au contraire être dans un matériau différent.

De plus, un tel appareil 1 peut aisément être fabriqué en grandes séries. En effet, les dissipateurs 4 sont d'une forme simple. En outre comme indiqué ci-dessus, tous les dissipateurs 4 d'un même appareil n'ont pas besoin d'être tous différents entre eux. Il est donc possible de fabriquer que quelques modèles de dissipateurs 4, qui sont ensuite fabriqués à grandes échelles. C'est le positionnement alterné des différents modèles de dissipateurs 4 qui permettra de créer des décalages dans les ouvertures 13.

Par exemple, on peut fabriquer au moins deux profilés de géométries différentes et découper chacun des profilés de sorte à former un premier groupe de dissipateurs 4 et un deuxième groupe de dissipateurs 4. La fabrication des profilés est ainsi simple et rapide. Comme déjà indiqué on peut même fabriquer un seul profilé et le découper en tronçon avec une inclinaison vis-à-vis de la direction axiale du profilé pour former les différents dissipateurs 4. Il faudra ensuite agencer les dissipateurs 4 avec une orientation différente vis-à-vis de la platine 2.

Un procédé de fabrication d'un tel appareil 1 va être décrit.

Dans une première étape, on fabrique la platine 2 (par extrusion, par injection ...). De préférence on fabrique la platine 2 de sorte qu'elle réponde à différentes contraintes liées à l'équipement électronique 100 associé (contraintes mécaniques, thermiques, radio, matériel ou « hardware » ...).

Dans une deuxième étape, on identifie parmi les composants portés par l'équipement électronique 100, qui est ou sera en regard de la platine 2, ceux qui vont dégager le plus de chaleur et/ou ceux qui sont les plus sensibles à la chaleur. On identifie ainsi les zones clés de la platine 2.

Dans une troisième étape, on fabrique les dissipateurs 4 (par extrusion, par injection ...) en fonction de ces zones clés (positionnements et/ou nombres et/ou étendues et/ou nombre de calories à évacuer).

Dans une quatrième étape, on assemble les dissipateurs 4 sur la platine 2 de sorte à positionner les dissipateurs 4 de préférence en face des zones clés. On comprend donc que les caractéristiques des zones clés (dimensions, nombre, localisations, nombre de calories à évacuer ...) permettent de caractériser les dissipateurs 4 (par exemple permettent de les dimensionner et par exemple de dimensionner leurs épaisseurs - selon l'axe Y) et de les positionner.

De préférence, en plus des dissipateurs 4 agencés en regard des interfaces thermiques, un ou plusieurs autres dissipateurs 4 peuvent être agencés sur la platine 2 afin de perturber davantage l'écoulement de l'air le long de la platine 2.

Par exemple dans le cas où l'appareil 1 est agencé à la verticale (l'axe Y s'étendant alors à la verticale), avec un écoulement d'air naturel, l'air chaud va avoir tendance à monter de sorte que l'air va naturellement s'écouler le long de l'axe Y de bas en haut. Il est donc préférable de placer les parois internes 14 sur cet axe pour gêner son déplacement.

Par exemple, avec un écoulement d'air forcé, il est préférable de placer les parois internes 14 sur l'axe de circulation de l'écoulement d'air forcé.

On a ainsi décrit des modes de réalisations permettant de générer des turbulences au sein d'un écoulement d'air traversant les dissipateurs 4.

On comprend donc que différentes solutions entrent ainsi dans le cadre de l'invention sont possibles. En effet, le décalage entre les ouvertures 13 peut se faire de plusieurs façons.

Selon une première option, au moins deux dissipateurs4 (identiques ou non) peuvent être décalés l'un de l'autre selon au moins un axe X, Y, Z.

Selon une deuxième option (combinable avec la première option), au moins deux dissipateurs 4 peuvent avoir une géométrie différente. Le but est alors de placer une paroi interne 14 de l'un des dissipateurs 4 en regard de l'ouverture 13 de l'autre des dissipateurs 4.

Selon une troisième option (combinable avec la première option et/ou la deuxième option), au moins deux dissipateurs 4 peuvent être décalés angulairement l'un de l'autre, les deux dissipateurs 4 ne s'étendant donc pas parallèlement l'un à l'autre. Le but est alors de diriger l'air d'un dissipateur 4 à un autre en lui faisant suivre un chemin non linéaire.

Bien entendu, l'invention n'est pas limitée aux modes de réalisation décrits mais englobe toute variante entrant dans le champ de l'invention telle que définie par les revendications.

En particulier il est possible de combiner les deux modes de réalisation et variantes décrits ci-dessus.

Ainsi les dissipateurs du premier mode de réalisation pourront comporter plusieurs étages comme dans le deuxième mode de réalisation. On pourra également avoir des dissipateurs parallèles entre eux comme dans le premier mode de réalisation mais avec au moins une paroi interne d'un dissipateur inclinée relativement à au moins une paroi interne d'un autre dissipateur de sorte à forcer l'écoulement à être réorienté différemment entre les deux dissipateurs concernés comme dans le deuxième mode de réalisation. Les premières parois des flancs latéraux du deuxième mode de réalisation pourront être orthogonaux aux parois inférieure et supérieure comme dans le premier mode de réalisation (seules les parois internes présenteront alors un angle d'inclinaison avec lesdites parois inférieure et/ou supérieure).

Les dissipateurs pourront avoir une autre forme que celle décrite et ainsi comporter un nombre différent d'ouvertures et/ou un nombre différent de parois internes et/ou un nombre différent d'étages que ce qui a été indiqué.

L'agencement des dissipateurs (par exemple l'espacement entre deux dissipateurs successifs) et/ou leur nombre et/ou leur forme (par exemple leur largeur) pourra être différent de ce qui a été indiqué. Par exemple, ceci déprendra de la géométrie globale de l'appareil et/ou de l'équipement électronique associé et notamment des dimensions de l'agencement de ses composants et interfaces thermiques et/ou des dimensions de la platine et/ou de la puissance thermique à dissiper. La séparation entre deux dissipateurs successifs pourra ne pas être régulière sur une série de dissipateurs appartenant au même appareil. Au moins un des dissipateurs pourra être un profilé ou un tronçon de profilé.

Bien qu'ici chaque orifice soit conformé de sorte à présenter une section transversale identique sur toute la largeur du dissipateur, au moins un orifice pourra présenter une section qui se modifie sur la largeur du dissipateur. Par exemple, au moins un orifice pourra se rétrécir entre les deux faces principales du dissipateur.

Bien qu'ici au moins un dissipateur soit muni d'au moins une patte, au moins un dissipateur pourra ne pas comporter de patte.

Bien qu'ici au moins un dissipateur comporte au moins une paroi supérieure, au moins un dissipateur pourra ne pas comporter de paroi inférieure.

## Revendications

1. Appareil de régulation thermique comprenant au moins :
- Une platine (2),
Au moins deux dissipateurs (4) rapportés sur la platine, chaque dissipateur comprenant au moins une ouverture (13), à travers laquelle un écoulement d'air est destiné à circuler, les deux dissipateurs étant rapportés sur la platine de sorte que leurs ouvertures soient décalées l'une par rapport à l'autre et/ou de sorte qu'au moins une paroi dessinant au moins une des ouvertures se trouve dans l'alignement de l'autre ouverture,
dans lequel les dissipateurs sont rapportés sur la platine de sorte à s'étendre les uns à la suite des autres selon un axe (Y),
**caractérisé en ce que** l'appareil comporte entre deux et six groupes de dissipateurs thermiques, les dissipateurs étant identiques au sein d'un même groupe mais différents entre deux groupes, les dissipateurs étant agencés de sorte à alterner sur au moins une zone de l'appareil successivement, selon l'axe (Y), un dissipateur de chacun des groupes.

2. Appareil selon la revendication 1, dans lequel au moins l'un des dissipateurs (4) présente un orifice et au moins une cloison (14) traversant ledit orifice de sorte à le découper en deux ouvertures (13).

3. Appareil selon la revendication 2, dans lequel la paroi se trouvant dans l'alignement de l'autre ouverture est la cloison (14).

4. Appareil selon l'une des revendications 2 à 3, dans lequel la cloison (14) a une épaisseur comprise entre 1 et 3 millimètres.

5. Appareil selon l'une des revendications 2 à 4 dans lequel la cloison (14) s'étend de manière inclinée relativement à au moins une paroi supérieure (7), une paroi inférieure (5) ou un flanc latéral (8) du dissipateur associé.

6. Appareil selon l'une des revendications précédentes, dans lequel chacun des dissipateurs (4) comporte une cloison (14) s'étendant de manière inclinée relativement à au moins une paroi supérieure (7), une paroi inférieure (5) ou un flanc latéral (8) du dissipateur associé.

7. Appareil selon l'une des revendications précédentes, dans lequel les ouvertures (13) sont décalées angulairement l'une par rapport à l'autre et/ou sont décalés transversalement l'une par rapport à l'autre.

8. Appareil selon l'une des revendications précédentes, dans lequel les dissipateurs (4) sont agencés de manière parallèle entre eux.

9. Appareil selon l'une des revendications précédentes, dans lequel les dissipateurs (4) sont décalés l'un de l'autre selon une direction longitudinale de la platine.

10. Appareil selon l'une des revendications précédentes, dans lequel les au moins deux dissipateurs (4) présentent une géométrie différente.

11. Appareil selon l'une des revendications précédentes, dans lequel la platine (2) et/ou au moins l'un des dissipateurs (4) est en ou à base d'alliage d'aluminium.

12. Appareil selon l'une des revendications précédentes, dans lequel la platine (2) et/ou au moins l'un des dissipateurs (4) est une pièce injectée ou extrudée.

13. Appareil selon l'une des revendications précédentes, dans lequel la platine (2) et au moins l'un des dissipateurs (4) sont dans le même matériau.

14. Appareil selon l'une des revendications précédentes, dans lequel au moins l'un des dissipateurs (4) est muni d'au moins une patte par l'intermédiaire duquel il repose contre la platine.

15. Equipement électronique équipé d'un appareil de régulation thermique selon l'une des revendications précédentes.

16. Equipement selon la revendication 15, dans lequel l'équipement électronique est une carte électronique.

## Patentansprüche

1. Gerät zur Wärmeregulierung, umfassend zumindest:
eine Platine (2),
zumindest zwei auf der Platine angebrachte Kühlkörper (4), wobei jeder Kühlkörper zumindest eine Öffnung (13) umfasst, durch welche ein Luftstrom hindurchfließt, wobei beide Kühlkörper derart auf der Platine angebracht sind, dass deren Öffnungen zueinander versetzt angeordnet sind und/oder dass zumindest eine Wand, die zumindest eine der Öffnungen bildet, in der Fluchtlinie der anderen Öffnung angeordnet ist,
wobei die Kühlkörper derart auf der Platine angebracht sind, dass sie sich entlang einer Achse (Y) hintereinander erstrecken,
**dadurch gekennzeichnet, dass** das Gerät zwischen zwei und sechs Kühlkörpergruppen enthält, wobei die Kühlkörper innerhalb einer Gruppe identisch sind, sich jedoch zwischen zwei Gruppen unterscheiden, wobei die Kühlkörper derart angeordnet sind, dass in zumindest einem Bereich des Geräts entlang einer Achse (Y) jeweils ein Kühlkörper aus jeder der Gruppen abwechselnd aufeinanderfolgen.

2. Gerät nach Anspruch 1, wobei zumindest einer der Kühlkörper (4) ein Loch und zumindest eine Trennwand (14) aufweist, die sich durch das Loch hindurch erstreckt und dieses in zwei Öffnungen (13) aufteilt.

3. Gerät nach Anspruch 2, wobei es sich bei der in der Fluchtlinie der anderen Öffnung befindlichen Wand um die Trennwand (14) handelt.

4. Gerät nach einem der Ansprüche 2 bis 3, wobei die Trennwand (14) eine Dicke von 1 bis 3 Millimeter aufweist.

5. Gerät nach einem der Ansprüche 2 bis 4, wobei sich die Trennwand (14) in Bezug auf zumindest eine obere Wand (7), eine untere Wand (5) oder eine Seitenwand (8) des zugehörigen Kühlkörpers geneigt erstreckt.

6. Gerät nach einem der vorhergehenden Ansprüche, wobei jeder der Kühlkörper (4) eine Trennwand (14) enthält, die sich in Bezug auf zumindest eine obere Wand (7), eine untere Wand (5) oder eine Seitenwand (8) des zugehörigen Kühlkörpers geneigt erstreckt.

7. Gerät nach einem der vorhergehenden Ansprüche, wobei die Öffnungen (13) winkelversetzt zueinander und/oder in Querrichtung versetzt zueinander angeordnet sind.

8. Gerät nach einem der vorhergehenden Ansprüche, wobei die Kühlkörper (4) parallel zueinander angeordnet sind.

9. Gerät nach einem der vorhergehenden Ansprüche, wobei die Kühlkörper (4) entlang einer Längsrichtung der Platine versetzt zueinander angeordnet sind.

10. Gerät nach einem der vorhergehenden Ansprüche, wobei die zumindest zwei Kühlkörper (4) eine unterschiedliche Geometrie aufweisen.

11. Gerät nach einem der vorhergehenden Ansprüche, wobei die Platine (2) und/oder zumindest einer der Kühlkörper (4) aus Aluminiumlegierung oder auf Aluminiumlegierungsbasis gefertigt sind/ist.

12. Gerät nach einem der vorhergehenden Ansprüche, wobei es sich bei der Platine (2) und/oder bei zumindest einem der Kühlkörper (4) um ein Spritzgussteil oder um ein extrudiertes Teil handelt.

13. Gerät nach einem der vorhergehenden Ansprüche, wobei die Platine (2) und zumindest einer der Kühlkörper (4) aus dem gleichen Material bestehen.

14. Gerät nach einem der vorhergehenden Ansprüche, wobei zumindest einer der Kühlkörper (4) mit zumindest einer Lasche versehen ist, über welche dieser auf der Platine aufliegt.

15. Elektronische Baugruppe, welche mit einem Gerät zur Wärmeregulierung nach einem der vorhergehenden Ansprüche ausgestattet ist.

16. Baugruppe nach Anspruch 15, wobei es sich bei der elektronischen Baugruppe um eine Elektronikkarte handelt.

## Claims

1. Thermal regulation device comprising at least:
- One plate (2),
- At least two heat sinks (4) fitted on the plate, each heat sink comprising at least one opening (13), through which an airflow is intended to circulate, the two heat sinks being fitted on the plate, such that their openings are offset against one another and/or such that at least one wall outlining at least one of the openings is located in the alignment of the other opening,
wherein the heat sinks are fitted on the plate, so as to extend following one another along an axis (Y),
being **characterized in that** the device comprises between two and six groups of thermal heat sinks, the heat sinks being identical within one same group, but different between two groups,
the heat sinks being arranged, so as to alternate on at least one zone of the device successively, along the axis (Y), a heat sink of each of the groups.

2. Device according to claim 1, wherein at least one of the heat sinks (4) has an orifice and at least one partition (14) passing through said orifice, so as to divide it into two openings (13).

3. Device according to claim 2, wherein the wall located in the alignment of the other opening is the partition (14).

4. Device according to one of claims 2 to 3, wherein the partition (14) has a thickness of between 1 and 3 millimetres.

5. Device according to one of claims 2 to 4, wherein the partition (14) extends inclined relative to at least one upper wall (7), a lower wall (5) or a side flank (8) of the associated heat sink.

6. Device according to one of the preceding claims, wherein each of the heat sinks (4) comprises a partition (14) extending inclined relative to at least one upper wall (7), a lower wall (5) or a side flank (8) of the associated dissipator.

7. Device according to one of the preceding claims, wherein the openings (13) are angularly offset against one another and/or are transversally offset against one another.

8. Device according to one of the preceding claims, wherein the heat sinks (4) are arranged parallel to one another.

9. Device according to one of the preceding claims, wherein the heat sinks (4) are offset from one another in a longitudinal direction of the plate.

10. Device according to one of the preceding claims, wherein the at least two heat sinks (4) have a different geometry.

11. Device according to one of the preceding claims, wherein the plate (2) and/or at least one of the heat sinks (4) is made of or based on aluminium alloy.

12. Device according to one of the preceding claims, wherein the plate (2) and/or at least one of the heat sinks (4) is an injected or extruded part.

13. Device according to one of the preceding claims, wherein the plate (2) and at least one of the heat sinks (4) are made of the same material.

14. Device according to one of the preceding claims, wherein at least one of the heat sinks (4) is provided with at least one tab by way of which it rests against the plate.

15. Piece of electronic equipment equipped with a thermal regulation device according to one of the preceding claims.

16. Piece of equipment according to claim 15, wherein the piece of electronic equipment is an electronic board.
